# EUROPEAN PATENT APPLICATION

(11) **EP 2 604 587 A1**
(43) Date of publication of application: **19.06.2013**
(21) Application number: 11193039.2
(22) Date of filing: 12.12.2011
(51) Int. Cl.: C04B 35/584, C04B 35/593, C04B 35/645, C04B 35/626, C23C 14/00, C23C 14/06, C23C 14/34

(54) **Electrically conductive SiNx ceramic composite, its sputtering targets and manufacturing methods thereof**

(71) Applicant: UMICORE, 1000 Brussels (BE)
(72) Inventor: Lippens, Paul, 2250 Olen (BE); Murez, Christophe, 2250 Olen (BE); Alvarez, Neil, 2250 Olen (BE); Shin, Jong-Won, 2250 Olen (BE)
(74) Representative: Umicore RDI Patent Department

(57) **Abstract**

A ceramic composite material comprising an aggregate chemical composition of SiNx, wherein x is between 0.2 and 1.30, a dispersed phase of Si₃N₄ particles, and a continuous phase of doped or intrinsic Si, wherein the dispersed phase of Si₃N₄ particles is imbedded in the continuous phase of doped or intrinsic Si.

A method of forming a ceramic composite material, the method comprising: preparing a mixture comprising x wt.% of α- Si₃N₄, y wt.% of undoped silicon, w wt.% of doped silicon, and z wt.% of boron, wherein x > 0, y ≥ 0, z ≥ 0, w ≥ 0 and wherein if y > 0 then z > 0; and forming a green body from the mixture.

## Description

### FIELD OF THE INVENTION

Ceramic composite materials made of material compositions composed of electrically non-conductive silicon-nitride material in combination with fractions of materials that render the overall article electrically conductive.

### BACKGROUND

Silicon-nitride coatings such as Si₃N₄ are typically sputter deposited using a fully reactive process with a mixture of inert gas Ar and a reactive gas such as N₂ or NH₃ or a mixture of the latter two gases starting from (doped) Si targets. It is also possible that H₂ is added to any of the gas mixtures. The electrical plasma discharge is typically sustained with mid-frequency AC (MF-AC) and a dual planar or dual rotary magnetron is used (for a state of the art on the technology: ref. article ATON-Applied Materials). In such reactive processes, high reactive gas flows or partial pressures are required so that transparent (quasi-stoichiometric) thin films are obtained. In such a process, not only the Si atoms which condense on the substrate react with N to form nitride molecules on the substrate, but also the target surface gets nitrided. A fully nitrided target surface or poisoned surface sputters at much lower rate than the corresponding metallic target. As silicon-nitride is a dielectric, arcing of the target starts to happen after a certain time, even with an MF-AC discharge. Sputtering with pulsed DC or, even worse, with DC will cause even more arcing to happen. Such arcing depletes coating quality considerably as it creates pinholes in the coating. Moreover, the arcing gives rise to loss of deposition rate. Stoichiometric Si3N4 sputtering targets can be sputtered in quasi-reactive mode with very little N2 or NH3 addition to the sputter gas and give rise to transparent coatings. However, such Si3N4 targets are non conducting and require radiofrequency (RF) power, i.e. power in the MHz range. RF sputter processes yield in general a low deposition rate. RF power is also not compatible with rotary magnetron technology. Also high RF power loads (of several kW) are difficult to shield from the rest of the coater aggregates so that electromagnetic interference with such aggregates easily happens. Large RF power supply units (of several kW in power) are also not readily available on the market. Hence, stoichiometric Si3N4 targets cannot solve the problem stated above.

### SUMMARY

A ceramic composite material comprising an aggregate chemical composition of SiNx, wherein x is between about 0.2 and about 1.30, a dispersed phase of Si₃N₄ particles, and a continuous phase of doped or intrinsic Si, wherein the dispersed phase of Si₃N₄ particles is imbedded in the continuous phase of doped or intrinsic Si.

A method of forming a ceramic composite material, the method comprising: preparing a mixture comprising x wt.% of α- Si₃N₄, y wt.% of undoped silicon, w wt.% of doped silicon, and z wt.% of boron, wherein x > 0, y ≥0, z ≥0, w ≥0 and wherein if y > 0 then z > 0; and forming a green body from the mixture.

A method of forming a ceramic composite material, the method comprising preparing a mixture comprising x wt.% of α- Si₃N₄, y wt.% of undoped silicon, w wt.% of doped silicon, z wt.% of boron, and v wt % of sinter additives, wherein x > 0, y ≥0, z ≥0, w ≥0 and wherein if y > 0 then z > 0, and in which 10 ≥ v ≥0 wt % and forming a green body from the mixture.

### DETAILED DESCRIPTION

The embodiments of the invention include a ceramic composite material comprising an aggregate chemical composition of SiNx, wherein x is between about 0.2 and about 1.30 (x is expressed in at %), a dispersed phase of Si₃N₄ particles, a continuous phase of doped or intrinsic Si, wherein the dispersed phase of Si₃N₄ particles is imbedded in the continuous phase of doped or intrinsic Si.

According to some embodiments, the ceramic composite material may be a sputtering target. In some embodiments, the ceramic composite material may be a conductive sputtering target. However, the ceramic composite material may be used in any sputtering related process or mechanism.

In certain aspects, the ceramic composite material may include several different materials, phases, or types of materials.

In certain embodiments, the chemical composition may be an aggregate chemical composition of SiNx. According to some embodiments, the ceramic composite material may include globally, or overall, several phases, whereby none of these phases by themselves may have the indicated chemical composition. In other embodiments, some of the phases or a subset of phases may include the chemical composition.

According to certain aspects, the ceramic composite material may include a dispersed phase of Si₃N₄ particles. In some embodiments, in the dispersed phase, the Si₃N₄ particles may be distributed randomly throughout the phase. In some embodiments, the particles may be evenly distributed throughout the phase.

According to some embodiments, the ceramic composite material may include the dispersed phase of Si₃N₄ particles which is imbedded in the continuous phase of doped-Si, whereby each particle of the dispersed phase may be surrounded by a continuous phase.

According to some embodiments, a composition of SiNx may be used or formed wherein x may be between about 0.2 and about 1.30. Without wishing to be bound by any particular theory, it is believed that the refractive index of a thin film, obtained when sputtering under pure inert gas (for example argon (Ar) or another inert gas) with a sputtering target according to some embodiments, will rise with x. If x is 1.30, then the refractive index n of the inert gas sputter deposited SiNx thin film will be close to or higher than 2.15 (at 630 nm). Additionally, the extinction coefficient k of the thin film will drop with a rising x value. However, the optical properties of the thin film (n and k) can still be tuned in the sputtering process by adding extra nitrogen with the sputter gas (any of the following gases can serve as nitrogen source: N₂, NH₃, mixtures of the preceding gasses and mixtures of any of the mentioned with H₂). The aggregate chemical composition of a sputtering target may not be copied in the thin film, some nitrogen might be lost due to re-combination into N₂ molecules in the plasma. With rising x values in the sputtering target, the target may become less electrically conductive.

For example, if, according to some embodiments, 90 wt % of Si₃N₄ is mixed with 10 wt % Si, then SiNx should contain 35.95 wt % N and 64.05 wt % Si or 52.95 at % N or x is 52.95/47.05 = 1.126; the stoichiometric material has x = 4/3 = 1.33. If only 20 wt % of Si₃N₄ is used, x = 0.174 only, far from the stoichiometric composition. This material will hence need a lot of nitrogen added as reactive gas in order to result in stoichiometric nitride coatings; such targets will be very conductive but will behave more or less equal to Si targets in a fully reactive sputtering process.

In some embodiments, the ceramic composite material includes a dispersed phase of, for example, Si₃N₄ particles. Without wishing to be bound by any particular theory, it is believed that this fraction of the material will, when used as or within a sputtering target, give rise to nitrogen atoms with high kinetic energy in the plasma which are hence highly reactive and which will easily react with the sputtered Si atoms upon condensing onto the substrate. This is unlike nitrogen atoms originating in the plasma from nitrogen molecules added as a sputtering gas which do not get/gain high kinetic energy. As a consequence, such nitrogen atoms cannot, by lack of surface mobility, easily find their place in a nitride lattice.

According to some embodiments, the ceramic composite material includes a continuous phase of doped-Si. In other embodiments, the ceramic composite material includes a continuous phase of intrinsic, undoped Si. Without wishing to be bound by any particular theory, the continuous phase may impart electrical conductivity to the ceramic composite material so that it can be used as a sputtering target in an industrial magnetron sputtering operation using MF-AC, pulsed DC or DC electrical power discharge. The conductivity of the ceramic composite material may depend on the fraction of continuous phase (vs. the dispersed phase of non conductive material such as Si₃N₄) and on the doping level of the continuous silicon phase. Intrinsic silicon normally does not have enough conductivity so as to enable the usage of any other power discharge than RF in a sputtering process. In a case where doped Si is used, MF-AC powering technology may be used in a sputtering process. According to some embodiments, dopants may be selected from the groups III or IV (boron, phosphorous, aluminium, gallium, arsenic, indium, antimony, thallium, bismuth) but also several transition metals could in principle be used. In one embodiment of the present invention, the continuous silicon phase is either boron or phosphorous doped.

According to some embodiments, the dispersed phase is imbedded in the continuous phase. For example, the dispersed phase of Si₃N₄ particles may be imbedded in the continuous phase of doped-Si. Alternatively, the dispersed phase of Si₃N₄ particles may be imbedded in the continuous phase of intrinsic, i.e. undoped Si. Without wishing to be bound by any particular theory, it is believed that the continuous phase of doped-Si may provide a conductive path through the target.

According to some embodiments, silica particles may be used as a sintering additive to make the ceramic composite material. Without wishing to be bound by any particular theory, such particles facilitate sintering when having a specific surface area (SSA as determined by the BET method) of min. 5 m²/g and when added in a volume of min. 0.05 wt % compared to the overall weight of precursor powders. As those silica particles remain imbedded in the continuous (doped or undoped) silicon phase of the ceramic composite material, thin films obtained from sputtering targets made with such ceramic composite material will have a slightly lower refractive index compared to thin films obtained from sputtering targets made with ceramic composite material of the embodiment without silica as sintering additive. It is believed that this is because SiO₂ has a refractive index n of 1.45 (at 510 nm). Hence, in order to obtain thin films with a relatively high refractive index (close to 2.65), the total amount of silica sintering additive could be kept below 5 wt %. In some cases however, where thin films with lower refractive index are required, the amount of silica sintering additive may be increased.

According to some embodiments, use silica as one of the sinter additives with a particle size determined by its specific surface area (SSA) as determined with the BET method of max. 500 m2/g and of which max. 10 wt % is added. Boron may also be added as a sinter additive in the form of boron compounds such as boron oxide or boron acid. A max. fraction of 2 wt% Y₂O₃ may also be added to SiO₂ leading to SiO2-Y₂O₃ compounds as sintering aid.

As the majority of the N, which condenses on the substrate together with the Si and reacts with it, is sputtered from the target as N-atoms with high kinetic energy, transparent SiNx(:H) coatings may be obtained without major additions of reactive gas (N2 or NH3 or a mix of both or any of the preceding gases or gas mixtures and H2) to the plasma. In some embodiments, the ceramic composite material may have enough conductivity to be used in a pulsed DC or MF-AC quasi-reactive process or in a DC sputter process.

According to some embodiments, the continuous phase of doped-Si comprises a conductive path through the SiNx target so that the bulk resistivity as measured on small bars with a square or circular cross section of the ceramic composite material with 4 probes (two current probes and two voltage probes) of < 10 mohm.cm is achieved. In other embodiments, a bulk resitivity of < 5 mohm.cm may be achieved, In yet other embodiments, a bulk resistivity of < 1 Ohm.cm may be achieved.

According to certain aspects, the ceramic composite material, which may be a conductive sputtering target, has enough conductivity to be used in an MF-AC (oscillating frequency 10-200 kHz) or even in a pulsed DC (pulsing frequency 1-350 kHz) magnetron metallic or reactive sputtering process.

In other aspects, the ceramic composite material, which may be a conductive sputtering target, has enough conductivity to be used in a DC magnetron sputter process at low power density (max. 7 W/cm²).

According to some aspects, the ceramic composite material may be used to form transparent SiNx thin films, SiNx:H and Si₃N₄ thin films and transparent SiNxOy thin films in sputtering processes which are primarily arc-free. These films have several advantages, such as, for example, the pinhole density of obtained coatings may be reduced. Coatings may also have an improved transparency (lower extinction coefficient over the visible and NIR) and a lower surface roughness.

Some of the advantages of the embodiments are that the transparent SiNx(:H) and other coatings are formed with considerably less addition of reactive gas to the sputter gas compared to the alternative process in which metallic Si targets are sputtered in reactive mode. In the latter process, a ratio of pure N2 to Ar flow of typically 1:1 (depending on the power load) may be needed according to some embodiments. Reactive gases that are avoided, partially avoided, or reduced may be, for example, N2, NH3, H2, H2O, 02, 03, N20 and any mixtures thereof. The drop in the above mentioned ratio of N2:Ar flow with the sputtering targets according to some embodiments may depend on x in the aggregate SiNx composition, but it may be more than 50 %.

According to certain aspects, the ceramic composite material may include a planar conductive sputtering target. In some embodiments, the ceramic composite material may include several planar tiles bonded to a backing plate.

In other embodiments, the ceramic composite material may include a rotary conductive sputtering target. In certain aspects, the ceramic composite material may include a plurality of cylindrical elements bonded to a backing tube.

According to some embodiments, the ceramic composite material, which may be a conductive sputtering target, may have a purity of higher than 99.9% (when taking into account Si, N and, in certain embodiments, O as constituent elements of the ceramic composite material). In other embodiments, the purity may be above 99.5%. However, other purities, such as higher than 99.0%, higher than 98.5% and higher than 98% are contemplated by some embodiments. With high purity ceramic composite materials, high purity sputtering targets may be produced, which can be used in quasi-reactive sputtering processes to make dielectric thin films with high breakdown voltages. Such thin films can be used e.g. as gate dielectrics in thin film transistors (TFT). Without wishing to be bound by any particular theory, ceramic composite materials with low purity may contain transition metals or metals from the groups IA, IIA, III, V which can act as a dopant or a trapping centre in silicon or silicon-compounds.

According to certain aspects, the ceramic composite materials may include a physical density of more than 95 % of its theoretical density (as measured by the Archimedes method). In other embodiments, the ceramic composite materials may include a physical density of more than 99 % of its theoretical density. High density targets may give rise to more stable sputtering processes (less arcing) at high power and reduce the formation of nodules due to re-deposition.

A reactive sputtering process using MF-AC and a twin pair of metallic rotary (doped) Si targets to form SiNx (with x appr. 1.30) coatings may show very little hysteresis (i.e. there is a one-to-one relation between reactive gas partial pressure and discharge voltage/deposition rate). However a strong dependence of aforementioned parameters and reactive gas partial pressure may be observed: discharge voltage in pure Ar (metal) mode may be e.g. > 500 V (e.g. at 6.67 kW/m MF-AC on a rotary target pair at 5E-03 mbar) whereas in poisoned mode, a discharge voltage of only 420 V may be measured. Such voltage drop may appear over a relatively small range of oxygen partial pressures (e.g. 3-5E-04 mbar). With the sputtering targets made from the ceramic composite material according to certain embodiments and depending on their conductivity and their aggregate composition (x in SiNx), there may also be a one-to-one dependence of sputter voltage/deposition rate on the reactive gas flow partial pressure. Nevertheless, the voltage range may be limited and the drop in voltage when adding reactive gas may be less steep (i.e. the transition mode covers a wider reactive gas partial pressure range).

According to some embodiments, ceramic composite materials and their related sputtering targets may be produced via sintering of a blend of powders, carefully selected so as to result in the indicated micro-structure including two phases (doped or undoped silicon as continuous phase and Si₃N₄ as dispersed phases) or three phases (doped or undoped silicon as continuous phase and Si₃N₄ and silica as dispersed phases) in which the dispersed phase(s) have a particle size of max. 10 µm, preferably max. 2 µm. The blend may include stoechiometric Si₃N₄ powder, and either doped-Si powder or alternatively a blend of undoped Si powder and B powder. As already indicated, the blend further may include sintering additives of which one can be silica particles with an SSA (BET) of > 5 m²/g. Between about 20 and 90 wt % of Si₃N₄ powder may be used in the blend and the conductivity of the target may depend on the composition of the blend. In some embodiments, the conductivity of the target may depend strongly on the composition of the blend.

In some embodiments, the electrically conductive SiNx targets may be produced with low cost pre-cursor materials, like those used in the manufacturing of structural ceramics, the resulting targets may be produced at a lower cost compared to state-of-the-art and ultra-high purity doped Si targets. Such ultra-high purity may, however, not be required for most of the applications in the field of focus.

The embodiments of the invention also include methods for forming a ceramic composite material by preparing a mixture comprising x wt.% of α- Si₃N₄, y wt.% of undoped silicon, w wt.% of doped silicon, and z wt.% of boron, wherein x > 0, y ≥0, z ≥0, w ≥0 and wherein if y > 0 then z > 0, and forming a green body from the mixture. According to some aspects, x may be between about 20 wt.% and about 90 wt. %.

In some embodiments, the ceramic composite material may be a conductive sputtering target.

According to some embodiments, a sintering aid may be added to the mixture. Examples of sintering aids may be, but are not limited to, silica-particles with SSA ≥ 5 m²/g added with min. 0.1 wt % and max. 5 wt%. In certain embodiments, the additives may be removed from the mixture. In some embodiments, the additives may be removed from the mixture by a low heat treatment. However, according to certain embodiments, silica particles cannot be removed from the green body and may be hence imbedded in the final ceramic.

According to some embodiments, oxygen content of the sinter body containing Silica or its compounds as sintering aid can be reduced by post- heat treatment under N₂ gas-pressured atmosphere.

According to some embodiments, powders of α- Si₃N₄, undoped Si and B may be selected in order to form the ceramic composite materials. In some embodiments, the α- Si₃N₄ powder may have a spherical morphology. In these or other embodiments, the α- Si₃N₄ powder may have an SSA = 3.5 - 12 m²/g (BET) with max. 250 ppm of metallic impurities. Examples of such powders may be obtained, for example, from Toray Ind., Japan or from Toyo Soda Man. Co., Ltd., Japan. In certain embodiments, the α-Si₃N₄ powder has a spherical morphology and a SSA = 3.5 - 12 m²/g (BET) with max. 250 ppm of metallic impurities. In other embodiments, the max ppm of metallic impurities may be 300 ppm max, 350 ppm max, 200 ppm max, 150 ppm max. While values in the range of 350 ppm max may lead to lesser quality targets, the production cost, however, may be lowered. On the other hand, obtaining higher quality targets by using 150 ppm max may increase the cost of the targets.

In certain embodiments, a blend of the above powders is prepared. Such blend may be prepared by, for example, using ball milling, a mechanical blender or similar techniques. Some embodiments utilize techniques such as, for example, attritor milling, planetary milling, and/or jet milling to form a slurry or dry powder blend. Several of these techniques may also be combined according to some embodiments. The powders may be blended in a slurry or they may be blended dry. In case of slurry processing, the powders are blended in a slurry containing a certain amount of primary powders in the aqueous phase together with organic additives. Such slurry may be spray dried to obtain granulates or agglomerates with the desired morphology and compaction properties. In dry blending, the powders may be mixed in a mechanical mixer with mixing blades or in a ball mill or planetary mill. The blending effect may be enhanced by addition of organic additives to make granulates or agglomerates for better compaction behaviour. In some embodiments, sinter aids may be added to the blend in this phase of the process.

According to certain embodiments, the powder is consolidated into a green body with organic additives such as binders or press aids. For example, the powder may be consolidated into a green body by using cold isostatic pressing (CIP) with typical pressure of about 1000 bar to about 4000 bar for about 1 to 20 min. According to some embodiments, the pressure may be about 1000 bar for about 10 min. According to certain embodiments, the powder is consolidated into a green body with organic additives such as a binders or press aids. For example, in order to achieve a planar geometry, the powder may be consolidated into a green body by using cold axial pressing with typical pressure between 15 MPa and 150 MPa, depending on powder preparation.

According to some embodiments, the additives may be removed by low temperature treatment of the green body. The heat treatment may be performed at between about room temperature and about 500°C whereby the organic additives may be removed from the green body without cracking the green body. To realize such a removal of organic additives by heat treatment, the heating rate may be kept low. In certain embodiments, the heating rate may be between 1-60 °C/h while in an oxidizing atmosphere.

According to some embodiments, the green body is sintered to a high density hybrid ceramic-metallic part. In some embodiments, the sintering may be done in an inert, in a reducing atmosphere, in a gas-pressured N₂ atmosphere or under a vacuum at about 1400°C, in any case at a temperature above 1250°C for about 8 hrs. In other embodiments, the sintering may be done in an inert atmosphere, in a reducing atmosphere, in a gas-pressured N₂ atmosphere or under a vacuum at more than 1250°C for more than about 8 hrs. According to some embodiments, the temperature may be about 1700°C. Alternatively, hot pressing or hot isostatic pressing can be used as a combined consolidation/sintering technique.

According to certain embodiments, the resulting parts may be machined to the final shape and/or ground to the final surface finish.

In some embodiments, several parts (planar tiles or cylindrical tubular segments) may be bonded to a backing tube so as to result in a sputtering target. Any technique known in the art may be used to bond the several parts to the backing tube. In some embodiments, the backing tube may be stainless steel or another customary backing tube material such as titanium.

According to some embodiments, the ceramic composite materials and/or conductive sputtering targets may be utilized in large area sputter deposition endeavours using equipment as known to those skilled in the art. In certain embodiments, without wishing to be bound by any particular theory, the ceramic composite material may be suitable for large area coating (LAC) because LAC may utilize large magnetrons with large targets. Consequently, a high sputter power may be needed. High sputter power may lead to more critical sputter processes with respect to arcing and coating uniformity. In certain embodiments, the ceramic composite materials may lead to increased target utilization above, for example, 70% or above, for example, 50%. In some embodiments, strong nodule formation is reduced or eliminated and as such target utilization is increased. Furthermore, continuous opening of the chamber and cleaning of the target may also be reduced or avoided.

The embodiments of the invention also include methods for forming a coating by magnetron sputtering the conductive sputtering target of claim 1 onto a surface. In some embodiments, the coating may be, for example, a transparent SiNx or SiNx(:H) or Si₃N₄ or SiOxNy coating, depending on the gas mixture used during sputter deposition. If only inert gas (e.g. Ar) is used during the sputtering process, then a thin film may be obtained which will more or less have the chemical composition of the target material, with the exception of a potential nitrogen loss due to recombination processes in the plasma.

According to some aspects, the coating was formed in an MF-AC or pulsed DC reactive or quasi-reactive magnetron sputtering process.

The embodiments of the invention include several additional advantages. For example, the conductive SiNx targets may be used in the photovoltaics' industry to deposit SiNx:H anti-reflective(AR)/passivation coatings for c-Si solar cells. They may increase productivity in this industry (since the sputter rate is higher than for doped Si targets in reactive mode) while at the same time resulting in coatings with better quality (less pinholes or other defects) which therefore protect the active area of the cell better against environmental influence. The targets may also be used to sputter SiOxNy (silicon-oxy-nitride) clear barrier coatings for TF-Si solar cells.

Without wishing to be bound by any particular theory, it is believed that it may be sufficient to add both 02 and N2 during the sputter deposition process in order to obtain an oxynitride. Such barrier (thickness may be 20 - 100 nm) may be sputter deposited onto clear float glass prior to depositing an Al:ZnO TCO (front contact). The barrier may prevent diffusion of metal atoms from the glass into the TCO and onward to the rest of the cell structure. Finally, certain new front side passivation concepts of c-Si solar cells use a very thin ( < 10 nm) SiOxNy:H passivation layer (directly in contact with the Si) underneath a thinner classical SiNx:H passivation coating (70 nm). Also such SiOxNy:H layers may be made with the targets according to the embodiments of the invention. As sputter stability of the conductive SiNx targets is much better than their metallic counterparts in reactive (poisoned) mode, defect-free coatings may be obtained using MF-AC or pulsed-DC (or DC-) sputtering which can be used as gate dielectric in a-Si TFT's for AM-LCD's. Such gate dielectrics are currently produced with PE-CVD but the deposition rate of the available technology is considerably inferior to sputter deposition. However, RF on Si₃N₄ targets may not be an option for gate dielectrics because of EMI shielding problems on sputter sources of large dimensions (more than 1 m in length). As the majority of production lines are Gen 5 or higher today (with substrates over 1 m in either dimension, requiring deposition sources of more than 1 meter length), RF cannot be used.

According to some embodiments, it was surprisingly found that the embodiments resulted in a transparent coating which was achieved easier than expected (high refractive index n and low extinction coefficient k). Without wishing to be bound by any particular theory, it is believed that the N that is reacting with the Si on the substrate surface is N with high kinetic energy coming from the target and not N coming from dissociated N2 gas added in the sputter gas (the latter is low energy).

According to some embodiments, cost will be reduced as deposition rate increases, pinhole density of obtained coatings will reduce, coatings with a better transparency (lower extinction coefficient over the visible and NIR) may be obtained. Other advantages of some embodiments of the invention may be avoiding poisoning of the surface and as such avoiding low deposition rates due to poisoned target surfaces, avoiding arcing, and improving surface quality and deposition rates.

### EXAMPLES

A rotary target pair according to the embodiments of the present invention is mounted in a Leybold Optics dynamic in-line coater A600V7 on a set of standard rotary magnetrons (of 600 mm target length) consisting of end-blocks from Sputtering Components Inc., Owatonna, USA (SCI) and Leybold Optics (Dresden, D) magnet arrays. The conductive ceramic material includes a starting blend of 20 wt % B-doped Si powder and 80 wt % Si₃N₄ powder. The target pair is sputtered with 40 kHz MF-AC in an Ar/N₂ gas flow (with 20 % N2 in the gas flow) at a pressure of 3.7E-03 mbar. A glass substrate is fed in a continuous way in front of the twin magnetron. For an MF-AC power of 8 kW (i.e. 13.33 kW/m), a typical dynamic deposition rate (DDR) of 50 nm.m/min is achieved (equivalent to 6.25 nm.m/(min.kW) or 3.75 nm.m/min per kW/m of power load). The appr. 80 nm SiNx coatings obtained in 3 passes at 2 m/min are completely transparent (exctinction coefficient in the visible < 1.E-03, average absorption in the visible (450-750 nm) < 1.5 %). The refractive index at 633 nm is appr. 2.10.

The comparative reactive process with two B-doped cast Si targets operated at the same MF-AC power load requires about 60 % N2 in the reactive gas flow to obtain transparent coatings with equivalent properties and yielded a dynamic deposition rate of only some 25 nm.m/min (equivalent to 1.875 nm.m/min per kW/m of power load).

R. Preu et al. (Proc. 16th EU-PVSEC, May 1-5, 2000) indicates a DDR of only 35 nm.m/min for a TwinMag used with MF-AC (40 kHz) and the alternative doped-Si targets in a fully reactive process (aimed at making SiNx:H passivation layers for c-Si solar cell). A few years later, W. Wolke et al., Proc. 19th EU-PVSEC, June 7-11, 2004, pp. 419-422, indicated a DDR of 40 nm.m/min again with planar doped Si targets used on a TwinMag (800 mm length). Although power load levels are not indicated in above publications, it can be assumed that power load had been selected in line with optimized economics of the coating deposition and so as to result in a stable process. These data all indicate a DDR considerably lower than the DDR reported with the targets according to the embodiments of the present invention.

Many modifications and variations of the embodiments of the invention are possible in light of the above teachings. It is, therefore, to be understood that within the scope of the appended claims, the invention may be practiced otherwise than as specifically described. The invention is defined by the claims.

Alternatively, the embodiments of the invention may be represented by the following clauses:
1. A ceramic material comprising:
   A composition of SiNx, wherein x is between about 0.2 and about 1.30;
   a phase of Si₃N₄ particles; and
   a continuous phase of Si, wherein the phase of Si₃N₄ particles is imbedded in the continuous phase of Si.
2. The ceramic material of clause 1, wherein the continuous phase of Si comprises a conductive path through the ceramic material so that the bulk resistivity of < 10mohm.cm is achieved.
3. The ceramic material of clause 1, wherein the ceramic material has enough conductivity to be used in an MF-AC (oscillating frequency 10-200 kHz) or even in a pulsed DC (pulsing frequency 1-350 kHz) magnetron metallic or reactive sputtering process.
4. The ceramic material of clause 1, wherein the ceramic material has enough conductivity to be used in a DC magnetron sputter process at a power density of less or equal than 7 W/cm2 in case of planar targets.
5. The ceramic composite material of clause 1, wherein the ceramic material is a conductive sputtering target.
6. The ceramic material of clause 1, wherein the ceramic material forms transparent SiNx, SiNx:H and Si₃N₄ thin films and transparent SiNxOy thin films.
7. The ceramic material of clause 6, wherein the transparent SiNx(:H) and other coatings are formed with considerably less addition of reactive gas to the sputter gas compared to the alternative process in which metallic Si targets are sputtered in reactive mode.
8. The ceramic material of clause 8, wherein the reactive gas is selected from the group consisting of N₂, NH₃, H₂, H₂O, O₂, O₃, N₂O and mixtures thereof.
9. The ceramic material of clause 1, wherein the conductive sputtering target is a planar target.
10. The ceramic material of clause 1, wherein the conductive sputtering target is a rotary target.
11. The ceramic material of clause 9, further comprising several planar tiles bonded to a backing plate.
12. The ceramic material of clause 10, further comprising a plurality of cylindrical elements bonded to a backing tube.
13. The ceramic material of clause 10, wherein the conductive sputtering target comprises a chemical purity of more than 99.9%.
14. The ceramic material of clause 10, further comprising a physical density of more than 97 % of its theoretical density (as measured by the Archimedes method),
15. The ceramic material of clause 10, further comprising a physical density of more than 99 % of its theoretical density.
16. A conductive sputtering target comprising:
   a composition of SiNx, wherein x is between about 0.2 and about 1.30; and non conductive Si₃N₄ particles imbedded in a continuous phase of conductive Si.
17. A ceramic composite material comprising:
   an aggregate chemical composition of SiNx, wherein x is between about 0.2 and
   about 1.30;
   a dispersed phase of Si₃N₄ particles; and
   a continuous phase of doped or intrinsic undoped-Si, wherein the dispersed phase of Si₃N₄ particles is imbedded in the continuous phase of doped or intrinsic-Si.
18. The conductive sputtering target of clause 17, wherein the conductive sputtering target is a planar target.
19. The conductive sputtering target of anyone of clauses 17-18, wherein the conductive sputtering target is a rotary target.
20. The conductive sputtering target of anyone of clauses 17-19, further comprising several planar tiles bonded to a backing plate.
21. The conductive sputtering target of anyone of clauses 17-20, further comprising a plurality of cylindrical elements bonded to a backing tube.
22. A method of forming a coating, the method comprising:
   forming a coating by magnetron sputtering the conductive sputtering target of claim 1 onto a surface.
23. The method of clause 22, wherein the coating is a transparent SiNx or SiNx(:H) or Si₃N₄ or SiOxNy coating.
24. The method of any one of clauses 22 or 23, wherein forming a coating by sputtering the conductive sputtering target comprises forming the coating in an MF-AC or pulsed DC reactive or quasi-reactive magnetron sputtering process.
25. The method of any one of clauses 22-24, wherein forming a coating by sputtering the conductive sputtering target comprises forming the coating in a DC magnetron sputter process.
26. The method of any one of clauses 22-25, wherein forming a coating comprises forming a large area coating.
27. A conductive sputtering target comprising:
   a composition of SiNx, wherein x is between about 0.2 and about 1.30; and
   non-conductive Si₃N₄ particles imbedded in a continuous phase of Si.

## Claims

1. A ceramic composite material comprising:
an aggregate chemical composition of SiNx, wherein x is between about 0.2 and
about 1.30;
a dispersed phase of Si₃N₄ particles; and
a continuous phase of doped or intrinsic undoped-Si, wherein the dispersed phase of Si₃N₄ particles is imbedded in the continuous phase of doped or intrinsic-Si.

2. The ceramic composite material of claim 1, wherein the ceramic composite material is a conductive sputtering target.

3. The ceramic composite material of any one of claims 1 or 2, wherein the continuous phase of doped-Si comprises a conductive path through the conductive sputtering target so that the bulk resistivity of < 10mohm.cm is achieved.

4. The ceramic composite material of any one of claim 1-3, wherein the conductive sputtering target has enough conductivity to be used in an MF-AC (oscillating frequency 10-200 kHz) or even in a pulsed DC (pulsing frequency 1-350 kHz) magnetron metallic or reactive sputtering process.

5. The ceramic composite material of anyone of claims 1-4, wherein the conductive sputtering target has enough conductivity to be used in a DC magnetron sputter process at a power density of less or equal than 7 W/cm2 in case of a planar magnetron.

6. The conductive sputtering target of anyone of claims 1-5, wherein the conductive sputtering target forms transparent SiNx, SiNx:H and Si₃N₄ thin films and transparent SiNxOy thin films.

7. The conductive sputtering target of anyone of claims 1-6, wherein the transparent SiNx(:H) and other coatings are formed with considerably less addition of reactive gas to the sputter gas compared to the alternative process in which metallic Si targets are sputtered in reactive mode.

8. The conductive sputtering target of anyone of claims 1-7, wherein the reactive gas is selected from the group consisting of N₂, NH₃, H₂, H₂O, O₂, O₃, N₂O and mixtures thereof.

9. The conductive sputtering target of anyone of claims 1-8, wherein the conductive sputtering target comprises a chemical purity of more than 99.9%.

10. The conductive sputtering target of anyone of claims 1-9, further comprising a physical density of more than 97 % of its theoretical density (as measured by the Archimedes method),

11. The conductive sputtering target of anyone of claims 1-10, further comprising a physical density of more than 99 % of its theoretical density.

12. A method of forming a ceramic composite material, the method comprising:
preparing a mixture comprising x wt.% of α- Si₃N₄, y wt.% of undoped silicon, w wt.% of doped silicon, and z wt.% of boron, wherein x > 0, y ≥0, z ≥0, w ≥0 and
wherein if y > 0 then z > 0; and
forming a green body from the mixture.

13. The method of claim 12, further comprising adding one or more sintering additives to the mixture.

14. The method of any one of claims 12 or 13, wherein one of the sintering additives is silica powder

15. The method of anyone of claims 12-14, wherein the silica powder has a specific surface area (SSA as measured with the BET technique) is min. 5 m2/g and is added with min. 0.1 wt % of the total blend.

16. The method of anyone of claims 12-15, further comprising removing additives from the mixture.

17. The method of anyone of claims 12-16, wherein x is between about 20 and about 90 wt. %.

18. The method of anyone of claims 12-17, wherein the mixture is prepared by a technique selected from the group consisting of ball milling, attritor milling, planetary milling, mechanical mixing and jet milling to form a slurry or dry powder blend.

19. The method of anyone of claims 12-18, wherein the slurry is spray dried to obtain a dry powder blend suitable for a cold or hot consolidation technique.

20. The method of anyone of claims 12-19, wherein forming the green body comprises consolidating the mixture into a green body by utilizing cold isostatic pressing.

21. The method of anyone of claims 12-20, wherein additives are removed by low temperature treatment of the green body.

22. The method of anyone of claims 12-21, further comprising sintering the green body to a high density hybrid ceramic-metallic part in an inert or reducing atmosphere at ≥1250 °C for ≥ 8 hours.

23. The method of anyone of claims 12-22, further comprising sintering the green body to a high density hybrid ceramic-metallic part by utilizing hot pressing or hot isostatic pressing.

24. The method of anyone of claims 12-23, further comprising bonding the high density hybrid ceramic-metallic part to a backing plate.

25. The method of anyone of claims 12-24, wherein the ceramic composite material is a conductive sputtering target.

26. A method of forming a coating, the method comprising:
forming a coating by magnetron sputtering the conductive sputtering target of claim 1 onto a surface.
